# FASCICULE DE BREVET EUROPEEN

(11) **EP 2 134 147 B1**
(45) Date de publication et mention de la délivrance du brevet: **08.08.2018**
(21) Numéro de dépôt: 09161821.5
(22) Date de dépôt: 03.06.2009
(51) Int. Cl.: H05K 1/02, H05K 3/34, H05K 1/11, H05K 3/30

(54) **Procédé de soudure et de positionnement d'un circuit intégré sur un substrat et assemblage réalisé par ce procédé**
Verfahren zum Auflöten und Positionieren einer integrierten Schaltung auf ein Substrat und mit diesem Verfahren hergestellte Anordnung
Method of soldering and positioning an integrated circuit on a substrate and assembly manufactured by this method

(30) Priorité: 09.06.2008 FR 0853816
(43) Date de publication de la demande: 16.12.2009
(73) Titulaire: Valeo Equipements Electriques Moteur, 94046 Créteil Cedex (FR)
(72) Inventeur: Mandion, Thierry, 77430, CHAMPAGNE SUR SEINE (FR); Chemin, Michaël, 51700, FESTIGNY (FR)
(74) Mandataire: Novembre, Christophe Adelphe

(56) Documents cités:
- EP-A- 0 341 629
- EP-A- 0 681 416
- EP-A1- 0 696 159
- CN-A- 1 725 930
- JP-A- 1 035 982
- JP-A- 6 177 492
- US-A- 5 912 438
- US-A1- 2005 042 852
- US-A1- 2007 000 684

## Description

L'invention concerne un procédé de soudure et de positionnement d'un circuit intégré à montage en surface sur un substrat à plages métalliques isolées.

Le circuit intégré précité est bien connu sous le sigle "CMS" pour "Composant à Montage en Surface" et cette abréviation sera utilisée ci-après dans un but de simplification de la description. Ce type de composant est encore connu sous la dénomination anglo-saxonne "SMD" (pour " Surface Mount Device")

De même, un "substrat à plages métalliques isolées" est généralement désigné sous le sigle anglo-saxon "IMS" (pour "Insulated Metal Substrate") et cette abréviation sera utilisée ci-après dans un but de simplification de la description. On parle également de technologie "SMT", pour "Surface Mount Technology" selon la dénomination anglo-saxonne.

On désigne par ce concept un type de carte électronique se composant d'un substrat dissipant à base métallique, d'une couche de matériau d'isolation et d'une couche de matériau conducteur en cuivre. L'avantage présenté par cette technologie est que la chaleur peut être conduite du composant à montage de surface vers un élément de dissipation thermique via le substrat.

CN1725930 A divulgue un dispositif assemblé comportant au moins un circuit intégré du type dit à montage en surface comprenant une pluralité de broches de sortie qui est assemblé sur un substrat formant un support isolant comportant au moins une première et une deuxième plages métalliques, électriquement isolées l'une de l'autre, présentant au moins deux bords linéaires en vis-á-vis et espacés d'une première distance déterminée, ledit circuit intégré comprenant au moins une première et une deuxième broches de sortie, de largeur déterminée et espacées d'une deuxième distance déterminée, destinées à être soudées sur lesdites première et deuxième plages métallisées électriquement isolées. CN1725930 A divulgue, de plus, des bandes de matériau isolant entre les broches qui sont aptes à être utilisées comme des repères d'index, mais ce document ne divulgue pas que pas que le positionnement et l'alignement sont effectivement réalisés par un procédé optique par utilisation desdites bandes comme repères d'index. Le procédé de l'invention concerne plus particulièrement des circuits intégrés de puissance implémentés dans un boîtier du type dit "D²PAK", et plus particulièrement encore dans un boîtier du type "D²PAK-7".

Dans ce qui suit, pour fixer les idées et sans limiter en quoi que ce soit la portée de l'invention, on se placera dans cette application préférée de l'invention, sauf mention contraire.

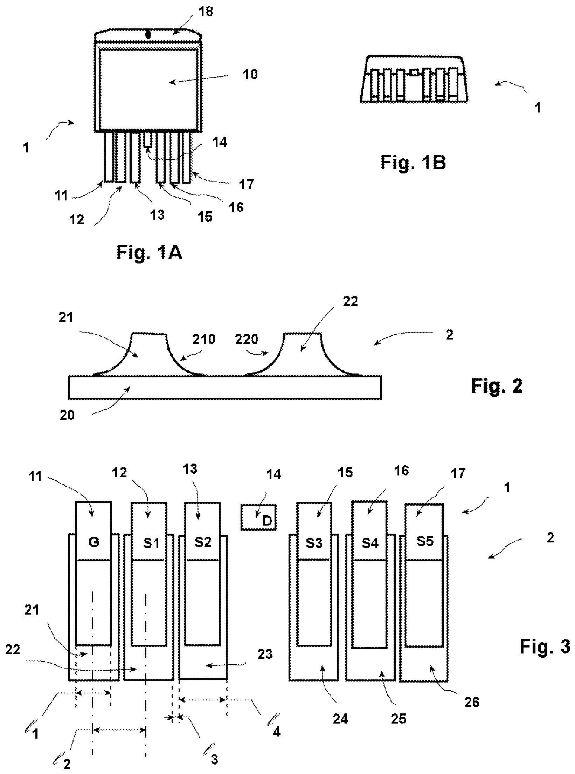

Les figures 1A et 1B, placées en fin de la présente description, illustrent la configuration d'un circuit intégré 1 du type "D²PAK-7", en vue de face et de côté, respectivement.

Des composants semi-conducteurs de puissance sont intégrés à l'intérieur du boîtier 10 du circuit intégré 1. Il s'agit généralement de transistors de forte puissance, par exemple de type "MOS-FET".

Un composant de type "D²PAK-7", comme illustré sur les figures 1A et 1B, comprend sept broches ou électrodes de sorties, numérotées 11 à 17, d'où le suffixe " - 7", le sigle "D²PAK" caractérisant la configuration du boîtier, ou "packaging" selon la terminologie anglo-saxonne généralement utilisée.

Le dos du boîtier 10 est muni d'une plaque métallique 18 formant un dissipateur de chaleur, encore appelé « case » selon la terminologie anglo-saxonne. Comme il est bien connu, cette plaque métallique 18 est destinée à être soudée sur une plage ou pastille métallique d'un circuit imprimé, plus généralement d'un substrat réalisée selon la technologie "IMS" précitée, comportant de telles plages en surface et une pluralité d'interconnexions métalliques conductrices de surface ou enterrées. Le métal généralement utilisé est du cuivre. Cette plaque métallique 18 est reliée électriquement à la broche 14, dite de drain d'un transistor MOS-FET.

Les autres broches, 11, dite de grille ou "gate" selon la dénomination anglo-saxonne plus généralement utilisée, 12 à 13 et 15 à 17, dites de sources, sont également soudées sur des plages métalliques du substrat de la manière précisée ci-après.

Les fortes puissances mises en jeu impliquent corrélativement des courants de fortes amplitudes, ce d'autant plus que, généralement, les tensions mises en oeuvres se situent dans des gammes d'amplitudes relativement peu élevées, voire des basses tensions.

Comme il est bien connu également, il est d'usage de multiplier le nombre de certaines broches attribuées à une même fonction, de manière à diminuer d'autant la résistance électrique des chemins empruntés par les courants circulant dans les broches.

On va maintenant expliciter le montage en surface par soudure d'un composant "CMS", notamment du type "D²PAK-7" (figures 1A et 1B), sur un substrat en recourant à la technologie "IMS" précitée par référence aux figures 2 et 3 placées en fin de la présente description.

Les éléments communs à ces deux figures portent les mêmes références et ne seront re-décrits qu'en tant que de besoin.

La figure 2 illustre schématiquement en coupe un substrat 2 comportant au moins une couche de matériau isolant 20 et des plages métalliques (à titre d'exemple deux, 21 et 22, ont été représentées sur cette figure). On dépose une couche de vernis, par exemple 27, entre les plages métalliques, 21 et 22.

Les broches du circuit intégré 1 implémenté dans un boîtier "D²PAK-7" (figures 1A ET 1B : 10), respectivement la grille G (référence 11), les sources S1 et S2 (références 12 et 13), et les sources S3 à S4 (références 15 à 17), sont destinées à être soudées sur des plages métalliques du substrat 2, respectivement 21 à 23 pour les broches 11 à 13 et 24 à 26 pour les broches 15 à 17. La broche 14 (drain D) est connectée à la plaque 18 dont la surface entière est soudée sur une plage métallique (non représentée) spécifique.

Si on se réfère aux spécifications des fournisseurs de circuits intégrés du type précité, c'est-à-dire si les règles de l'art pour implémenter correctement de tels circuits, ces spécifications imposent que les plages précitées, 21 à 23 et 24 à 26, correspondant aux broches 11 à 13 et 24 à 26, respectivement, débordent de part et d'autre de ce broches. Cette disposition est illustrée par la figure 3. Le débordement des deux côtés est avantageux car il permet un positionnement optique des broches par rapport aux plages métalliques du substrat de bonne qualité, par tout procédé approprié. De tels procédés sont bien connus de l'Homme de Métier et ne nécessitent pas de plus amples développements.

Cette disposition présente par contre un inconvénient car la distance séparant d1 deux plages adjacentes est faible, ce d'autant plus que les plages métalliques, par exemple 21 et 22 (figure 2), ne sont pas constituées de parallélépipèdes rectangles parfaits. En bordures des plages, 21 et 22, on observe une décroissance douce (en forme de ménisque), ce qui implique que la distance réelle subsistant entre deux plages adjacentes d2 est inférieure à la distance théorique d1 (distance nécessaire pour obtenir un débordement donné).

Pour fixer les idées, des valeurs dimensionnelles typiques caractérisant le dispositif assemblé de la figure 3 sont les suivantes :
- épaisseur des plages métalliques : e (figure 2) = 210 mm ;
- largeur des broches, 11 à13 et 25 à 26, L₁ = 0,75 mm ;
- pas entre deux axes de broches, L₂ = 1,27mm ; et
- largeur des plages métalliques, 21 à 23 et 24 à 26, L₄ = 0,9 mm.

Toujours pour fixer les idées, dans ces conditions, les fournisseurs de circuits imprimés imposent une distance entre plages métalliques adjacentes de 0,52 mm minimum pour éviter tout risque de court-circuit lié au procédé de gravure de la couche conductrice, entre plages adjacentes.

Si on prend en compte les valeurs rappelées ci-dessus, on obtient une distance L₃ théorique entre les plages métalliques 21 et 22 sous-jacentes aux broches de grille G (référence 11) et de première source S1 (référence 12) qui ne peut être supérieure à 0,37 mm, ce qui est bien inférieure aux règles édictées par les fournisseurs de circuits imprimés et de composants.

Il s'ensuit que l'on ne peut plus, dans ces conditions, déposer une couche de vernis d'isolation entre les plages métalliques (figure 2 : 27), ce qui augmente fortement les risques de court-circuit lors du procédé de soudage.

Des essais pratiques effectués sur 2400 dispositifs assemblés ont montré, toujours dans ces conditions, que 80 % des dispositifs assemblés réalisés étaient défectueux car on a constaté des courts-circuits entre la grille G (référence 11) et la première source S1 (référence 12).

Pour ce type de montage, le problème d'isolement se pose d'ailleurs essentiellement entre la broche de grille G (référence 11) et la première broche de source S1 (référence 12).

Partant de cette constatation, selon une des caractéristiques importantes de l'invention, les plages métalliques, sous-jacentes à ces deux broches sont réalisées de façon à ce qu'elles ne débordent plus dans la zone inter-broches. En d'autres termes, leurs positionnements dans l'espace sont déterminés de façon à ce que la distance les séparant soit égale à celle séparant les deux broches. Les plages métalliques peuvent toutefois être plus larges que les broches de façon à déborder du côté opposé à la zone inter-broches.

Dans un mode de réalisation préféré, dans le cas d'un composant du type "D²PAK-7" ou similaire, la plage sous-jacente à la broche de première source peut se prolonger sous la broche de deuxième source. De même, la plage sous-jacente à la broche de troisième source peut être commune aux broches de quatrième et cinquième sources.

Il est possible ainsi d'augmenter la distance critique séparant les deux plages sous-jacentes aux broches de grille et de première source, ce qui est suffisant pour respecter les spécifications précitées imposées par les fournisseurs de circuits imprimés et de composants.

Dans l'exemple rappelé ci-dessus, la distance entre les plages 21 et 22 deviendrait L₃ = 0,985 mm, ce qui bien supérieur à la valeur minimale spécifiée de 0,52 mm. Cette valeur L₃ permet de nouveau de déposer du vernis dans l'espace inter-broches et évite tout risque de court-circuit.

On doit noter que la tenue mécanique n'en est pas pour autant affectée, ni la qualité de la soudure, ce à la condition exprès qu'un positionnement (alignement) relatif parfait des broches concernées (G et S1) par rapport aux plages métalliques qui leurs sont sous-jacentes soit réalisé.

Ce positionnement devient plus difficile à réaliser. Il devient en effet plus difficile de centrer optiquement les broches de grille et de première source sur les deux premières plages, puisque la bande de débordement dans la zone inter-broches n'existe plus. En outre, si les autres broches sont soudées sur des plages en tout ou partie communes à plusieurs broches, le positionnement précis ne peut être obtenu, ce qui augmente de nouveau les risques de courts-circuits inter-broches du fait d'un alignement incorrect du jeu de broches sur les plages métalliques.

Il existe donc un besoin accru de contrôle optique des soudures de broches sur les plages métalliques du substrat.

L'invention vise à remplir ce besoin et à pallier les inconvénients des dispositifs de l'art connu, et dont certains viennent d'être rappelés.

Aussi, selon une autre caractéristique importante de l'invention, des bandes de vernis sont disposées systématiquement en surface du substrat, entre les deux premières plages métalliques, d'une part, et dans les zones de ce substrat destinées à définir des zones inter broches, même lorsque celles-ci sont recouvertes d'une couche métallique formant les plages métalliques sur lesquelles sont soudées les broches.

Selon cette caractéristique importante, les bandes de vernis servent de repères d'index pour le positionnement optique précis des broches par rapport aux plages métalliques, ce malgré l'absence d'un double débordement de part et d'autre des broches.

En outre, la première bande de vernis sert également d'isolant entre les plages sous-jacentes aux broches de grille et de première source, respectivement.

Le procédé de soudure et de positionnement conforme à l'invention permet donc, simultanément, d'éviter tout risque de court-circuit et l'obtention d'un alignement précis des broches par rapport aux plages métalliques du substrat.

L'invention a donc pour objet principal un procédé de positionnement d'un circuit intégré du type dit à montage en surface selon la revendication 1. L'invention va maintenant être décrite de façon plus détaillée en se référant aux dessins annexés, parmi lesquels :
- les figures 1A et 1B illustrent un circuit intégré implémenté dans un boîtier de type "D²PAK-7", en vues de face et de côté, respectivement ;
- la figure 2 illustre schématiquement un substrat comportant des plages métalliques isolées, du type dit "IMS", pour la soudure d'un circuit intégré en faisant appel à une technologie dite à montage de surface ;
- la figure 3 illustre schématiquement un exemple de réalisation d'un dispositif assemblé de circuit intégré, du type illustré par les figures 1A et 1B, sur le substrat de la figure 2, selon l'art connu ;

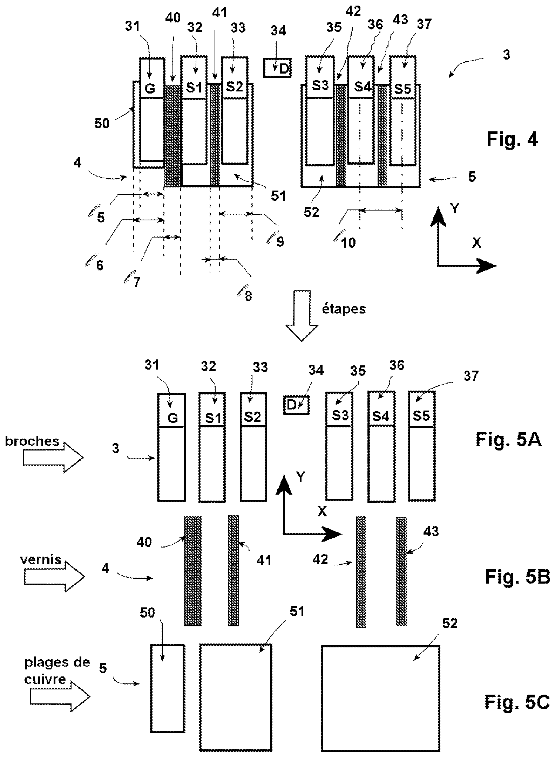

- la figure 4 illustre schématiquement un exemple de réalisation d'un dispositif assemblé de circuit intégré, du type illustré par les figures 1A et 1B, sur le substrat de la figure 2, selon un mode de réalisation préféré de l'invention ; et
- les figures 5A à 5C illustrent les étapes de réalisation du dispositif assemblé de la figure 4.

Dans ce qui suit, sans en limiter en quoi que ce soit la portée, on se placera ci-après dans le cadre de l'application préférée de l'invention, sauf mention contraire, c'est-à-dire la réalisation d'un dispositif assemblé, par soudure, d'un circuit intégré du type "D²PAK-7" sur un substrat de type "IMS" dont l'épaisseur de la couche conductrice est ≥ 105 µm, c'est-à-dire comportant des plages métalliques isolées, par la technologie dite de "montage en surface" ou "SMT" précitée.

On doit bien comprendre que, en soi, la technologie de soudure des composants à montage de surface mise en oeuvre pour la réalisation de dispositifs assemblés selon l'art connu (par exemple celui décrit en regard des figures et 3), est entièrement compatible avec le procédé de l'invention, ce qui constitue un avantage supplémentaire, car il n'est pas nécessaire de recourir à des technologies spécifiques.

Le procédé conforme à l'invention va maintenant être illustré en regard de la description des figures 4 et 5A à 5C.

Les éléments communs à ces figures portent les mêmes références et ne seront re-décrits qu'en tant que de besoin. La figure 4 illustre schématiquement un exemple de réalisation d'un dispositif assemblé de circuit intégré "D²PAK-7", c'est-à-dire du type illustré par les figures 1A et 1B, sur un substrat spécifique à l'invention.

Le circuit intégré de type à montage de surface, désormais référencé 3, n'est naturellement pas spécifique à l'invention. On peut choisir un composant du commerce identique ou tout à fait semblable à celui décrit sur les figures 1A et 1B. Dans l'exemple décrit, concernant le domaine d'application préféré de l'invention, il s'agit d'un circuit intégré implémenté dans un boîtier de type "D²PAK-7" comportant, par définition, sept broches de sortie : une grille G (référencée 31), un drain D (référencée 34) et des sources S1 à S5 (référencées 32 et 33 et 37 à 37, respectivement).

Comme il a été indiqué, la broche de drain D (référencée 34) est particulière, car connecté à une plaque de dissipation thermique localisée à l'arrière du boîtier (figure 1A : 18) soudée sur une plage particulière du substrat (non représentée), localisée en dehors des zones inter-broches des autres broches de sortie. La soudure de cette broche n'est pas concernée par le procédé propre à l'invention. Elle n'est d'ailleurs pas spécifiquement concernée par les règles d'implémentation éditées par les fournisseurs de circuits imprimés et de composants de type à montage de surface.

Comme il a été rappelé, l'espacement critique à préserver entre deux broches concerne essentiellement celui exempte de plage métallique entre les broches de grille G (référencée 31) et de première source S1 (référencée 32)

Aussi pour augmenter la distance entre les deux plages métalliques sous-jacentes à ces broches de sortie, 50 et 51, selon une première caractéristique importante de l'invention, les dimensions géométriques de ces plages, 50 et 51, et leurs positions dans l'espace, c'est-à-dire en surface d'un substrat isolant (figure 2 : 20) sont déterminées de telle sorte que, lorsque le circuit intégré sera soudé sur ces plages, elles ne débordent pas dans la zone inter-broches. En d'autres termes, la distance L₇ qui les sépare est sensiblement égale à la distance séparant la broche de grille G (référencée 31) de la broche de première source S1 (référencée 32), les bords en vis-à-vis affleurant les bords correspondant des broches de grille G et de première source S1.

Comme dans l'art connu (figure 3), la plage 50 déborde de la broche de grille G, du côté opposé à la zone inter-broches précitée.

La plage 51 peut être commune aux broches de première et deuxième sources, S1 et S2, respectivement. Elle est alors sous-jacente aux deux broches et déborde de la broche de deuxième source S2, du côté opposé à la zone inter-broches G - S1.

Il en est de même de la plage 52 qui peut être commune aux broches de troisième à cinquième sources, S3 à S5, respectivement. Cette plage 52 déborde, sur ces côtés opposés, des broches S3 et S4, de façon identique, ou pour le moins similaire, à l'art connu, en ce qui concerne ce dernier point.

De façon également semblable à l'art connu, les extrémités des plages, 50 à 52, débordent des extrémités des broches (dans un sens longitudinal).

Cette disposition permet de diminuer la résistance électrique au passage du courant et une meilleure dissipation thermique.

La disposition propre à l'invention, qui consiste à ne faire déborder les plages sous-jacentes aux broches de grille G et de première source S1 que d'un seul côté et de laisser libre l'espace inter-broches permet de respecter les exigences des fournisseurs de circuits imprimés, car la distance d'isolement est suffisante pour éviter tout risque de court-circuit par la dépose d'un matériau isolant de type vernis.

Cependant, cette caractéristique avantageuse, pour se vérifier, exige que le circuit intégré 3, lors de son montage par soudure sur les plages métalliques, 50 à 52, d'un substrat isolant (par exemple figure 2 : 20) soit parfaitement aligné sur ces plages, le point critique restant l'alignement des broches de grille G et de première source S1. On doit comprendre par "alignement" un positionnement du circuit intégré 3 et de ses broches, 31 à 37, selon deux axes orthonormés, que l'on dénommera arbitrairement X et Y, Y étant parallèle à la plus grande dimensions des broches. Les plages métalliques, 50 à 52, se présentent sous la forme de zones généralement de forme rectangulaire, dont les côtés sont parallèles aux axes X et Y. Il est donc nécessaire, d'une part, que les axes longitudinaux des broches restent alignés sur l'axe Y (pour éviter un décalage angulaire), et, d'autres part, que, notamment, les bords des broches de grille G et de première source S1, soient parfaitement alignés avec les bords en vis-à-vis des plages 50 et 51 qui leur sont sous-jacentes, pour conserver une distance de sécurité d'isolement suffisante afin d'éviter tous risque de court-circuit.

Or, les repères servant à obtenir un alignement, effectué comme il est connu par des moyens otiques approprié, sont réduits du fait, notamment, de la disparition des débordements de plages métalliques dans la zone inter-broches grille G - première source S1, zone particulièrement critique comme il a été rappelé.

En effet, par effet de symétrie, dans l'art connu, on obtenait un positionnement correct en visant les zones de débordement de part et d'autres des broches précitées et en équilibrant leurs surfaces respectives, ce qui n'est plus possible, du moins plus difficile à obtenir, en particulier si la plage 51 est commune aux broches de première S1 et deuxième source S2. Le positionnement précis de la broche de grille par rapport à la surface de la plage métallique ne peut reposer que sur l'estimation de l'aire de débordement de la plage 50, du côté opposé à la zone inter-broches.

Aussi, selon une deuxième caractéristique très importante du procédé de l'invention, on dépose une série 4 de bandes de vernis isolant, d'une part une bande 40 déposée dans la zone située entre les plages 50 et 51, c'est-à-dire dans la zone qui sera située entre la broche de grille G et de première source S1 après soudure, et, d'autre part, des bandes 41 à 43, dans des zones superficielles des plages métalliques, 51 et 52, situées entre les autres broches (32, 33, et 35 à 37) lorsqu'elles seront soudées sur ces plages métalliques.

La première bande de vernis 40 couvre toute la surface de la zone inter-broches G - S1, et sa largeur L₇ est égale à la distance séparant les plages, 50 et 51, c'est-à-dire également à la distance inter-broches.

Les autres bandes de vernis, 41 à 43, sont plus étroites, leurs largeurs L₈ est donc telle que L₈ < L₇ et L₈ < L₃. Elles sont positionnées dans l'espace de manière à laisser des zones libres entre elles et les bords en vis-à-vis de deux broches consécutives.

Ces dispositions permettent d'utiliser les bandes de vernis, 40 à 41, comme repères d'indexage pour le positionnement et l'alignement précis des broches de sortie du circuit intégré 3 sur l'ensemble 5 de plages métalliques, 50 à 52.

En outre, la bande de vernis 40, qui couvre tout l'espace inter-broches participe à la bonne isolation, l'une par rapport à l'autre, des électrodes de grille G et de première source S1.

Il devient aisé, à l'aide de moyens optiques classiques, bien connu de l'Homme de Métier, de viser les bandes de vernis, 40 à 43, servant d'index et d'équilibrer les aires des zones libres de vernis entre électrodes des bandes 41 à 43, même si les plages métalliques sont communes à plusieurs broches, ce qui est le cas des plages 51 et 52 dans le mode de réalisation préféré de l'invention qui est décrit sur les figures 4 à 5C.

Les figures 5A à 5C illustrent les trois couches superficielles successives, 3 à 5, d'un substrat de type "IMS" (le substrat isolant formant support n'étant pas représenté sur les figures 4 et 5A à5C), et par là les étapes successives du procédé selon l'invention :
- dépôt d'une couche de métal 5, généralement du cuivre, sur un support isolant, pour obtenir des zones de métallisation sélective : plages 50 à 52 ;
- dépôt d'une pluralité 4 de bandes de vernis, 40 à 43, sur la surface des plages métallique (par exemple les bandes 41 à 43) ou entre deux plages métalliques (par exemple la bande 40) ; et
- positionnement des broches (du moins en ce qui concerne les broches 31 à 33 et 35 à 37) du circuit intégré 3 en utilisant les bandes de vernis, 40 à 43, comme index et soudure de ces boches sur les plages métalliques.

Comme il a été rappelé, le procédé de l'invention ne nécessite pas de faire appel à des techniques et technologies spécifiques, ce qui présente un avantage supplémentaire. En particulier, le positionnement et l'alignement des broches peut s'effectuer en faisant appel à tout procédé optique approprié et l'opération de soudure s'effectue en faisant appel également à des procédés bien connus en soi.

Pour fixer les idées, des valeurs dimensionnelles typiques caractérisant le assemblage de la figure 4 sont les suivantes :
- épaisseur des plages métalliques : e (voir figure 2) = 210 µm ;
- largeur des broches, 31 à 33 et 35 à 36, L₅ = 0,75 mm ;
- pas entre deux axes de broches, L₁₀ = 1,27mm ;
- largeur de la première bande de vernis 40, L₇ = 0,52mm ;
- largeur des autres bandes de vernis, 41 à 42, L₈ = 0,37 mm ;
- largeur de la plage métallisée 51 entre la bande de vernis 41 et son bord extrême débordant de la broche de deuxième source S2, L₉ = 0,9 mm ;
   et
- largeur de la plage métallisée 50, L₆ = 0,9 mm.

La largeur L₆ de la première plage métallisée 50 peut être quelconque, à condition que cette dernière déborde la broche G sur son côté opposé à la zone inter-broches G-S1 : L₆ > 0,75 mm = L₅.

Il subsiste donc un débordement unique de la plage métallisée 50 sur le bord de la broche de grille G (référencée 31) opposé à la zone inter-broches G-S1. Il subsiste des zones libres de vernis entre les broches S1 et S2, S3 et S4, et S4 et S5, de par et d'autre des bandes de vernis, 41 à 43, de largeurs égales à 0,075 mm. On constate bien que la distance inter-plages 50-51 qui correspond à la largeur L₇ de la première bande de vernis 40 est de 0,52 mm, ce qui est conforme aux règles d'implémentation édictées par les fournisseurs de circuits intégrés.

De nombreux essais ont été effectués par la Demanderesse sur des cartes de circuits imprimés réalisées conformément au procédé de l'invention, il n'a été constaté aucune disfonctionnement du à un mauvais alignement des circuits intégrés ou à des courts-circuits entre broches, en particulier entre les broches de grille G et de première source S1.

A la lecture de ce qui précède, on constate aisément que l'invention atteint bien les buts qu'elles s'est fixée, et qu'il est inutile de rappeler entièrement.

Le procédé selon l'invention permet tout à la fois d'obtenir une très bonne isolation entre électrodes, notamment les électrodes critiques de grille et de première source dans le cas des composants semi-conducteurs implémentés dans un boîtier de type "D²PAK-7" (de façon plus générale "D²PAK"), en augmentant la distance subsistant entre les plages métallisées sous-jacentes à ces broches de sortie, ce qui évite tout risque de court-circuit, et de conserver la possibilité de réaliser un positionnement et un alignement des broches de ces composants très précis.

Toutefois, l'invention n'est pas limitée aux seuls modes de réalisation explicitement décrits en regard des figures 4 à 5C, ni seulement à l'application préférée relative à la réalisation d'un dispositif assemblé de composants implémentés dans des boîtiers de type "D²PAK" ou similaires.

Le procédé selon l'invention trouve application, *a priori,* pour tout type de composant à montage en surface ("SMD"), pour le moins quand les caractéristiques dimensionnelles impliquent, à la fois, des espacements minimum critiques entre plages métallisées sous-jacentes d'un substrat isolant formant support sur lesquelles les boches du composant sont soudées, et un positionnement et un alignement très précis sur la géométrie de ces plages métallisées.

Naturellement également, un dispositif assemblé réalisé selon le procédé conforme à l'invention peut comprendre un nombre quelconque de composants à montage en surface, et n'est en aucun cas limité à un seul composant comme il a été décrit dans les exemples montrés sur les figures 4 à 5C, dans le seul but de préciser de façon détaillée les caractéristiques essentielles de l'invention. Comme il est bien connu, les différents composants sont connectés les uns aux autres, soit par des faisceaux de conducteurs imprimés en surface, voir enterrés pour un circuit imprimé multicouches, voire par des connexions filaires entre plages métallisées, pour réaliser, en tant que de besoin, des circuits électroniques d'architecture plus ou moins complexe. Cet aspect est tout à fait commun, en soi, avec l'art connu et il n'y a pas lieu de le développer plus avant.

## Revendications

1. Procédé de positionnement d'un circuit intégré du type dit à montage en surface comprenant une pluralité de broches de sortie et de soudure desdites broches de sortie sur une pluralité de plages métalliques réalisées sur un substrat formant un support isolant, ladite pluralité de plages métalliques comportant une première et une deuxième plages métalliques, électriquement isolées l'une de l'autre, présentant deux bords linéaires en vis-à-vis et espacés d'une première distance déterminée, ledit circuit intégré comprenant une première et une deuxième broches de sortie et une pluralité de broches de sortie supplémentaires, lesdites première et deuxième broches de sortie ayant une largeur déterminée, étant espacées d'une deuxième distance déterminée et étant destinées à être soudées sur lesdites première et deuxième plages métallisées électriquement isolées, respectivement, le procédé comprenant au moins les étapes suivantes :
- le dépôt sur une face dite supérieure dudit substrat formant support isolant (20) de ladite pluralité de plages métalliques comprenant lesdites première (50) et deuxième (51) plages métallisées qui sont déposées en des zones prédéterminées, de manière à ce que ladite première distance soit sensiblement égale à ladite deuxième distance (L₇) et la largeur (L₆) de ladite première plage métallisée soit au moins égale à ladite largeur (L₅) déterminée de première broche de sortie (31) ;
- le dépôt d'une bande (40) de matériau isolant dans l'ensemble d'une zone délimitée par les bords en vis-à-vis desdites première (50) et deuxième (51) plages métallisées, ladite bande (40) de matériau isolant assurant une isolation électrique entre lesdites première et deuxième plages métallisées (50, 51) et constituant un premier repère d'index ;
- le dépôt, pour chaque paire de broches de sortie supplémentaires, d'une bande (41 à 43) de matériau isolant supplémentaire dans des zones situées entre les broches de chaque paire, lesdites bandes (41 à 43) de matériau isolant supplémentaires constituant des deuxièmes repères d'index ; et
- le positionnement et l'alignement, par un procédé optique, des bords en vis-à-vis desdites première et deuxième broches de sortie (31, 32) sur les bords en vis-à-vis desdites première et deuxième plages métallisées (50, 51) par utilisation dudit premier repère d'index et desdits deuxièmes repères d'index, et la soudure des broches de sortie sur les plages métallisées correspondantes.

2. Procédé selon la revendication 1, **caractérisé en ce que** la dite étape de dépôt de plages métallisées consiste à déposer, en sus de ladite première plage métallisée (50), au moins une plage métallisé supplémentaire (51 à 52), commune à tout ou partie desdites broches de sortie supplémentaires (33 à 37).

3. Procédé selon l'une des revendication 1 ou 2, **caractérisé en ce que** lesdites bandes de matériau isolant supplémentaires (41 à 43) ont une largeur inférieure à ladite deuxième distance déterminée (L₇) entre deux broches, de manière à laisser subsister, de par et d'autre desdites bandes de matériau isolant, un espace libre entre ces bandes de matériau isolant (41 à 43) et les bords en vis-à-vis des broches (32, 33, 35 à 37) de chacune desdites paires, et à faciliter lesdits positionnement et alignement.

4. Procédé selon la revendication l'une quelconque des revendications précédentes, **caractérisé en ce que** ladite première plage métallisée (50) a une largeur (L₆) supérieure à la largeur (L₅) de ladite première broche (31), de manière à ce qu'elle déborde de cette broche (31) d'une distance déterminée, du côté opposé à la zone localisée entre lesdites première (31) et deuxième (32) broches.

5. Procédé selon l'une quelconque des revendications précédentes, **caractérisé en ce que** ledit circuit intégré à montage de surface (3) étant un composant semi-conducteur de puissance du type dit "MOS-FET", implémenté dans un boîtier du type dit "D²PAK-7", ledit composant (3) comprenant sept broches de sorties reliés à un circuit de grille (31), un circuit de drain (34) et cinq circuits de source (32, 33, 35 à 37), ladite grille (31) constituant ladite première broche et la première source (32) ladite deuxième broche, ladite étape de dépôt de plages métallisées comprend le dépôt d'au moins une plage métallisée (51, 52) commune à tout ou partie des dites broches de source (32, 33, 35 à 37) sur laquelle elles seront soudées et **en ce que** lesdites bandes de matériau isolant supplémentaires (41 à 43) sont déposées sur lesdites plages métallisées communes (51, 52).

6. Procédé selon l'une quelconque des revendications précédentes, **caractérisé en ce que** ledit matériau isolant est un vernis.

7. Procédé selon l'une quelconque des revendications précédentes, **caractérisé en ce que** le matériau constitutif des dites plages métallisées (50 à 52) est du cuivre.

8. Procédé selon la revendication 7, **caractérisé en ce que** le matériau de cuivre constitutif des dites plages métallisées (50 à 52) a une épaisseur supérieure ou égale à 105 microns (µm).

## Patentansprüche

1. Verfahren zum Positionieren einer integrierten Schaltung vom so genannten Typ mit Oberflächenmontage, umfassend eine Vielzahl von Ausgangspins, zum Auflöten der Ausgangspins auf eine Vielzahl von metallischen Bereichen, die auf einem Substrat, das einen Isolierträger bildet, hergestellt sind, wobei die Vielzahl von metallischen Bereichen einen ersten und einen zweiten metallischen Bereich umfasst, die voneinander elektrisch isoliert sind, die zwei gegenüberliegende und um einen ersten bestimmten Abstand beabstandete lineare Ränder aufweisen, wobei die integrierte Schaltung einen ersten und einen zweiten Ausgangspin und eine Vielzahl von zusätzlichen Ausgangspins umfasst, wobei der erste und zweite Ausgangspin eine bestimmte Breite haben, um einen zweiten bestimmten Abstand beabstandet sind und dazu bestimmt sind, auf den ersten bzw. zweiten elektrisch isolierten metallisierten Bereich aufgelötet zu werden, wobei das Verfahren mindestens die folgenden Schritte umfasst:
- auf eine so genannte Oberseite des einen Isolierträger (20) bildenden Substrats Aufbringen der Vielzahl von metallischen Bereichen, umfassend den ersten (50) und zweiten (51) metallisierten Bereich, die an vorbestimmten Zonen aufgebracht werden, so dass der erste Abstand im Wesentlichen gleich dem zweiten Abstand (L₇) ist, und die Breite (L₆) des ersten metallisierten Bereichs mindestens gleich der bestimmten Breite (L₅) des ersten Ausgangspins (31) ist;
- Aufbringen eines Isoliermaterialstreifens (40) in der Gesamtheit einer Zone, die von den gegenüberliegenden Rändern der ersten (50) und zweiten (51) metallisierten Bereiche begrenzt ist, wobei der Isoliermaterialstreifen (40) eine elektrische Isolierung zwischen den ersten und zweiten metallisierten Bereichen (50, 51) gewährleistet und eine erste Indexmarkierung darstellt;
- für jedes Paar von zusätzlichen Ausgangspins Aufbringen eines zusätzlichen Isoliermaterialstreifens (41 bis 43) in Zonen, die sich zwischen den Pins jedes Paars befinden, wobei die zusätzlichen Isoliermaterialstreifen (41 bis 43) zweite Indexmarkierungen darstellen; und
- durch ein optisches Verfahren Positionieren und Ausrichten der gegenüberliegenden Ränder der ersten und zweiten Ausgangspins (31, 32) an den gegenüberliegenden Rändern der ersten und zweiten metallisierten Bereiche (50, 51) durch Verwendung der ersten Indexmarkierung und der zweiten Indexmarkierungen und Auflöten der Ausgangspins auf die entsprechenden metallisierten Bereiche.

2. Verfahren nach Anspruch 1, **dadurch gekennzeichnet, dass** der Schritt des Aufbringens von metallisierten Bereichen darin besteht, zusätzlich zum ersten metallisierten Bereich (50) mindestens einen zusätzlichen metallisierten Bereich (51 bis 52) aufzubringen, der allen oder einem Teil der zusätzlichen Ausgangspins (33 bis 37) gemeinsam ist.

3. Verfahren nach einem der Ansprüche 1 oder 2, **dadurch gekennzeichnet, dass** die zusätzlichen Isoliermaterialstreifen (41 bis 43) eine geringere Breite als der zweite bestimmte Abstand (L₇) zwischen zwei Pins hat, um beiderseits der Isoliermaterialstreifen einen Freiraum zwischen diesen Isoliermaterialstreifen (41 bis 43) und den gegenüberliegenden Rändern der Pins (32, 33, 35 bis 37) jedes der Paare bestehen zu lassen und das Positionieren und Ausrichten zu erleichtern.

4. Verfahren nach einem der vorhergehenden Ansprüche, **dadurch gekennzeichnet, dass** der erste metallisierte Bereich (50) eine größere Breite (L₆) als die Breite (L₅) des ersten Pins (31) hat, so dass er über diesen Pin (31) um einen bestimmten Abstand auf Zone der der zwischen den ersten (31) und zweiten (32) Pins gegenüberliegenden Seite hinausragt.

5. Verfahren nach einem der vorhergehenden Ansprüche, **dadurch gekennzeichnet, dass**, wobei die integrierte Schaltung mit Oberflächenmontage (3) eine Halbleiterleistungskomponente vom Typ "MOS-FET" ist, die in ein Gehäuse vom Typ "D²PAK-7" implementiert ist, wobei die Komponente (3) sieben Ausgangspins umfasst, die an eine Gate-Schaltung (31), eine Drain-Schaltung (34) und fünf Source-Schaltungen (32, 33, 35 bis 37) angeschlossen sind, wobei das Gate (31) den ersten Pin und die erste Source (32) den zweiten Pin bildet, der Schritt des Aufbringens von metallisierten Bereichen das Aufbringen mindestens eines metallisierten Bereichs (51, 52) umfasst, der allen oder einem Teil der Source-Pins (32, 33, 35 bis 37), auf den sie aufgelötet werden, gemeinsam ist, und dass die zusätzlichen Isoliermaterialstreifen (41 bis 43) auf die gemeinsamen metallisierten Bereiche (51, 52) aufgebracht werden.

6. Verfahren nach einem der vorhergehenden Ansprüche, **dadurch gekennzeichnet, dass** das Isoliermaterial ein Lack ist.

7. Verfahren nach einem der vorhergehenden Ansprüche, **dadurch gekennzeichnet, dass** das Material, aus dem die metallisierten Bereiche (50 bis 52) bestehen, Kupfer ist.

8. Verfahren nach Anspruch 7, **dadurch gekennzeichnet, dass** das Kupfermaterial, aus dem die metallisierten Bereiche (50 bis 52) bestehen, eine Dicke größer oder gleich 105 Mikrometer (µm) hat.

## Claims

1. Method for positioning what is termed a surface-mounted integrated circuit comprising a plurality of output pins and for soldering said output pins to a plurality of metal pads produced on a substrate forming an insulating support, said plurality of metal pads including a first and a second metal pad that are electrically insulated from one another, having two mutually facing linear edges that are spaced apart by a first given distance, said integrated circuit comprising a first and a second output pin and a plurality of additional output pins, said first and second output pins having a given width, being spaced apart by a second given distance and being intended to be soldered to said first and second electrically insulated metallized pads, respectively, the method comprising at least the following steps:
- depositing, on what is termed an upper face of said substrate, forming an insulating support (20), said plurality of metal pads comprising said first (50) and second (51) metallized pads, which are deposited in predetermined areas, such that said first distance is substantially equal to said second distance (L₇) and the width (L₆) of said first metallized pad is at least equal to said given width (L₅) of the first output pin (31);
- depositing a strip (40) of insulating material in the entirety of an area delineated by the mutually facing edges of said first (50) and second (51) metallized pads, said strip (40) of insulating material providing electrical insulation between said first and second metallized pads (50, 51) and forming a first index marker;
- depositing, for each pair of additional output pins, an additional strip (41 to 43) of insulating material in areas situated between the pins of each pair, said additional strips (41 to 43) of insulating material forming second index markers; and
- positioning and aligning, using an optical method, the mutually facing edges of said first and second output pins (31, 32) on the mutually facing edges of said first and second metallized pads (50, 51) using said first index marker and said second index markers, and soldering the output pins to the corresponding metallized pads.

2. Method according to Claim 1, **characterized in that** said step of depositing metallized pads consists in depositing, in addition to said first metallized pad (50), at least one additional metallized pad (51 to 52), common to all or some of said additional output pins (33 to 37).

3. Method according to either of Claims 1 and 2, **characterized in that** said additional strips of insulating material (41 to 43) have a width smaller than said second given distance (L₇) between two pins, so as to leave, on both sides of said strips of insulating material, a free space between these strips of insulating material (41 to 43) and the mutually facing edges of the pins (32, 33, 35 to 37) of each of said pairs, and to facilitate said positioning and alignment.

4. Method according to any one of the preceding claims, **characterized in that** said first metallized pad (50) has a width (L₆) greater than the width (L₅) of said first pin (31), such that it extends beyond this pin (31) by a given distance, on the side opposite the area located between said first (31) and second (32) pins.

5. Method according to any one of the preceding claims, **characterized in that**, said surface-mounted integrated circuit (3) being what is termed a 'MOSFET' power semiconductor component implemented in what is termed a 'D²PAK-7' housing, said component (3) comprising seven output pins that are linked to a gate circuit (31), a drain circuit (34) and five source circuits (32, 33, 35 to 37), said gate (31) forming said first pin and the first source (32) forming said second pin, said step of depositing metallized pads comprises depositing at least one metallized pad (51, 52) common to all or some of said source pins (32, 33, 35 to 37) to which they will be soldered, and **in that** said additional strips of insulating material (41 to 43) are deposited on said common metallized pads (51, 52).

6. Method according to any one of the preceding claims, **characterized in that** said insulating material is a varnish.

7. Method according to any one of the preceding claims, **characterized in that** the material forming said metallized pads (50 to 52) is copper.

8. Method according to Claim 7, **characterized in that** the copper material forming said metallized pads (50 to 52) has a thickness greater than or equal to 105 microns (µm).
